# EUROPEAN PATENT SPECIFICATION

(11) **EP 0 753 699 B1**
(45) Date of publication and mention of the grant of the patent: **19.09.2001**
(21) Application number: 96302304.9
(22) Date of filing: 01.04.1996
(51) Int. Cl.: F16M 13/02, G01R 1/04, G12B 9/08

(54) **Instrument tilt bail with stepped projections**
Bügel mit stufenweisen Vorsprüngen zur Neigung eines Instruments
Volet à gradins pour supporter et pencher un instrument

(30) Priority: 14.07.1995 US 503072
(43) Date of publication of application: 15.01.1997
(73) Proprietor: FLUKE CORPORATION, Everett, Washington 98206-9090 (US)
(72) Inventor: Teesink, Johannes H.G., 7443 EA Nijverdal (NL)
(74) Representative: Burke, Steven David

(56) References cited:
- US-A- 2 388 567
- US-A- 3 878 964
- US-A- 4 508 459
- US-A- 4 940 204
- US-A- 4 984 760

## Description

The present Invention relates generally to bails attached to instruments and, more particularly, to tilt bails that are suitable for hanging or supporting portable electronic test instruments.

Portable electronic instruments are typically designed to be handheld or supported by a stand or from a hanger during use. The stand or hanger for an instrument is commonly referred to as a bail. Many conventional bails function both as a stand and a hanger for the instrument. When used as a stand, the bail supports the instrument while It is resting on a bench or other work surface. When used as a hanger, the bail suspends the instrument from an object, such as a pipe or door frame.

Typically, bails are attached to the instrument case or to a holster that holds the instrument, and may be hinged at the point of attachment so that the bail can be stored in a closed position against the case or holster when not in use. When the instrument is to be used, the bail may be swung away from the instrument to an open position from which it may function as a stand or hanger.

Some instrument bails in the prior art have a somewhat rigid construction, while other known bails are flexible. Rigid bails presumably are better for supporting heavier instruments and may be less expensive to manufacture than the flexible type. On the other hand, flexible bails offer certain advantages over rigid bails. A flexible bail may be bent to present the instrument at a variety of viewing angles or to permit it to be hanged from irregularly shaped objects. One such flexible bail is the subject matter of United States Patent No. 4,940,204 and is assigned to John Fluke Mfg. Corp., Inc.

Unfortunately, conventional bails, whether rigid or flexible, have certain limitations and drawbacks. Flexible bails may not be strong enough to support relatively large or heavy portable instruments. When used as a stand, a flexible bail may simply bend under the weight of the instrument and when used as a hanger, a heavy instrument may straighten out the bail from which it is hung, thereby allowing the instrument to fall.

Service technicians, who typically use portable test instruments, often need to work inside electrical panels, service cabinets or other enclosures that have access doors. Many times the most convenient, and safe, location for the instrument when in use is hanging it from the opened door. Instruments with conventional bails typically are not well suited for hanging from doors. Rigid bails do not fit securely over the door frame and flexible bails may give way under the weight of the instrument. In addition, doors often vary in thickness, further complicating the use of conventional bails. As a result, the technician may be forced to place the instrument on the floor or in another less convenient, and perhaps less safe, location.

Accordingly, there is a need for a tilt bail that will serve equally well as a stand for an electronic test instrument and as a hanger for hanging the instrument from a door or other structure. Furthermore, there is a need for such a bail that may be used a relatively large or heavy test instrument. The present invention, directed to a tilt bail with stepped projections, is designed to achieve these results.

### Summary of the Invention

Aspects of the present invention are set out in the accompanying claims.

A tilt bail of the preferred embodiment for a portable test instrument with a substantially planar back surface includes an elongate member with a hinged end for pivotal attachment to the back of the instrument. The bail may be rotated between closed and open positions. A series of stepped projections extend from the elongate member toward the instrument. Each one of the projections have a first surface and a second surface perpendicular to the first surface. When the bail is rotated to a predetermined open position, the first and second surfaces of the projections are parallel and perpendicular to the back of the instrument. When the instrument and open bail are placed on a door or other object having a generally rectangular cross section, adjacent first and second surfaces of the stepped projections are brought into contact with the door so as to permit the instrument to be securely hung from the door.

As will be appreciated from the foregoing summary, the present invention provides a tilt bail with stepped projections that enables a portable test instrument to be securely hung from a door or other generally rectangular object.

### Brief Description of the Drawings

Aspects of this invention will become more readily appreciated as the same becomes better understood by reference to the following description of a preferred embodiment taken in conjunction with the accompanying drawings, wherein:
FIG. 1 is a side elevational view of a tilt bail in accordance with the present invention shown supporting an instrument in a standing position;
FIG. 2 is a side elevational view of the bail of FIG 1 shown supporting an instrument in a hanging position;
FIG. 3 is a front perspective view of a preferred embodiment of a bail according to the present invention;
FIG. 4 is a front perspective view of an alternative embodiment of a bail according to the present invention; and,
FIG. 5 is a front perspective view of another alternative embodiment of a bail according to the present invention.

### Description of the Preferred Embodiment

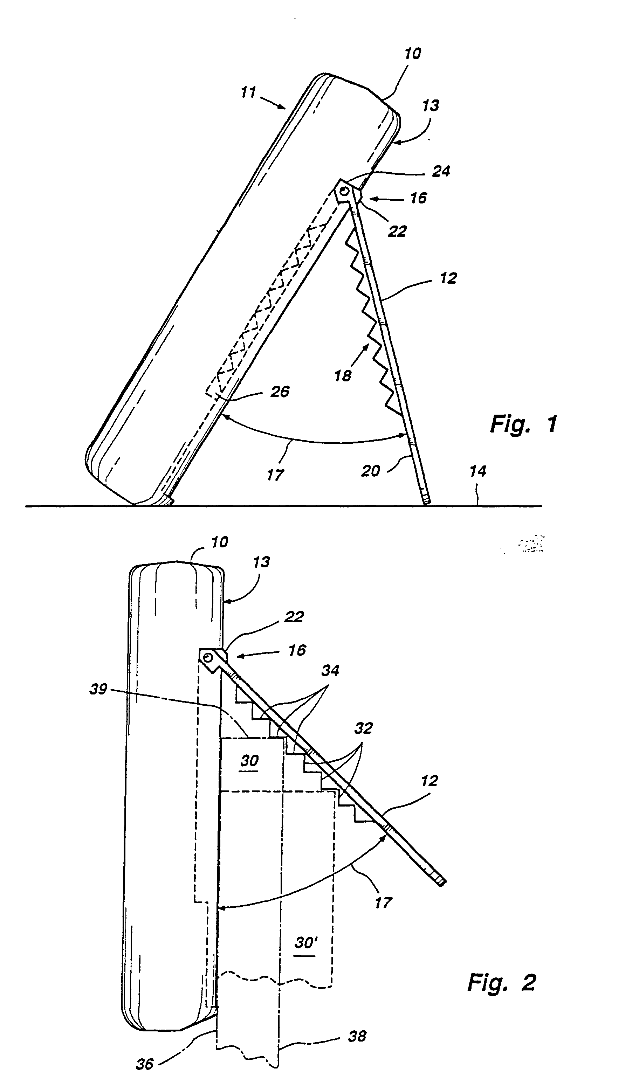

FIG. 1 illustrates an instrument 10 supported by a bail 12 in a standing position on surface 14. Instrument 10 has a front 11 and a back 13. In accordance with the preferred embodiment, bail 12 is pivotally attached at one end 16 to the back 11 of instrument 10. When utilized as a stand, bail 12 is rotated about end 16 to a predetermined open position at an angle 17 relative to instrument 10. A built up area, or shoulder, 22 positioned near end 16 is brought to rest against a surface 24 of the instrument 10 when the bail is rotated to its open position and acts to prevent further opening of the bail. Preferably, bail 12 is constructed from generally rigid material, such as molded plastic or sheet metal, that has sufficient strength to support instrument 10 in the standing position.

A series of stepped projections 18 extend outwardly from a surface 20 of bail 12. Surface 20 generally faces the instrument 10 so that projections 18 extend from the bail toward the instrument. The significance of the stepped projections 18 will become better understood from the discussion below and with reference to FIG. 2.

FIG. 1 also illustrates the bail 12 in its closed position. When closed, bail 12 is brought to rest in recessed area 26 in the back of the instrument 10. In FIG. 1, bail 12 is represented in its closed position by dashed lines. In its closed position, the bail 12 is out of the way and a technician can easily hold the instrument in his or her hand.

FIG. 2 illustrates the use of bail 12 as an instrument hanger. As shown in FIG. 2, bail 12 acts as a hanger to support instrument 10 from an object, such as a door 30. Bail 12 is opened to its predetermined position (angle 17) and placed over the door 30. As oriented in FIG. 2, the back 13 of the instrument 10 is adjacent a front surface 36 of the door 30 and a portion of the projections 18 are adjacent back and top surfaces 38, 39 of the door.

As illustrated in FIGs. 1 and 2, each one of the stepped projections 18 includes two surfaces (32, 34) oriented at right angles to one another. When the bail is opened to its predetermined position, first surfaces 32 are oriented in a parallel relationship with the back surface 13 of the instrument 10 and second surfaces 34 are oriented in a perpendicular relationship with the back 13 of the instrument. As illustrated in FIG. 2, surfaces 32 and 34 are also parallel to adjacent door surfaces 38, 39, respectively. The right angle relationship of surfaces 32, 34 in cooperation with the substantially planar back surface 13 of instrument 10 permits the instrument 10 to be securely hung from a door or other object having a generally rectangular cross section.

As discussed above, the bail is opened to a predetermined position when utilized to support the instrument in a standing position. In accordance with the presently preferred embodiment of the invention, the opened position is forty five degrees (45°) from its closed position (angle 17 in FIGs. 1 and 2), which also corresponds to 45° relative to the back 13 of the instrument 10. It is to be understood, however, that the angle of the opened bail may be other than 45°, without affecting the performance of the bail. If the angle is different, the angle of the parallel and perpendicular surfaces of the projections, relative to the bail, must also change. What must remain the same in order to achieve the benefits of the present invention is that the surfaces 32, 34 of the stepped projections 18 must remain generally parallel and perpendicular to the back surface of the instrument when the bail is in its open position. Accordingly, the particular angle of the opened bail relative to the instrument, and the relative angle between the elongate member 20 and the projections 18, while related, are not critical elements of the present invention.

The tilt bail of the present invention is readily adaptable for hanging the instrument 10 from doors of different thicknesses. This feature is illustrated in FIG. 2, in which another door 30' is shown by dashed lines. Door 30' is thicker than door 30, yet the stepped projections 18 of bail 12 permit instrument 10 to be securely supported from the door 30'.

In accordance with the presently preferred embodiment of the invention, instrument 10 in FIGs. 1 and 2 may also represent a holster for holding an instrument. Accordingly, bail 12 may be readily attached to the instrument holster and recessed area 26 would reside in the holster. Thus, the relationship between the instrument 10 and bail 12 discussed herein and illustrated in FIGs. 1 and 2 apply equally to an instrument holster and bail arrangement.

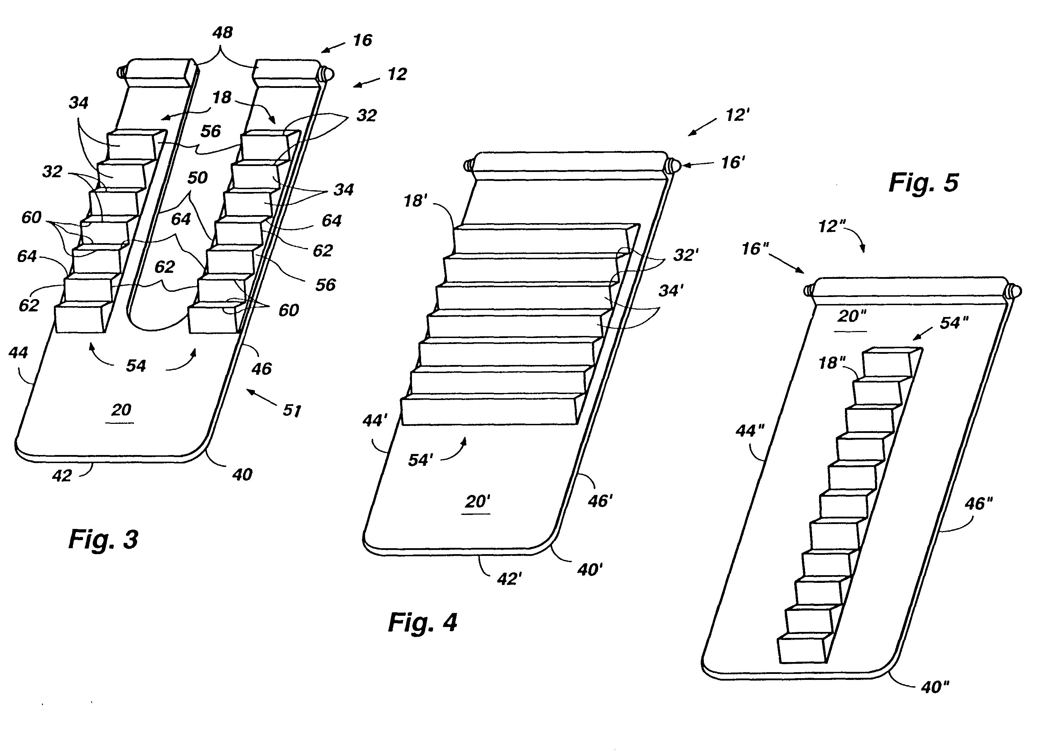

FIGs. 3, 4 and 5 illustrate different embodiments of the bail 12. The presently preferred embodiment of the bail 12 is depicted in FIG. 3, and comprises an elongate member 40 with hinged end 16 and second, opposite, end 42; parallel sides 44 and 46; and a substantially planar surface 20 extending there between. Elongate member 40 is further defined by parallel, spaced apart fingers 50 extending from hinged end 16 and joining at lower area 51, which extends to end 42. Hinged end 16 includes a pair of hinge members 48 at the end of fingers 50. Bail 12 has a length defined by ends 16 and 42 and a width defined by sides 44, 46. According to the preferred embodiment, the length of the bail 12 is substantially greater than its width.

Stepped projections 18 are arranged longitudinally, in two columns 54 along the fingers 50. As depicted in FIG. 3, the stepped projections 18 of each of the columns 54 are adjacent one another and spaced apart from the hinged end 16 and second end 42. As discussed above, and further illustrated in FIG. 3, each one of the stepped projections 18 includes surfaces 32 and 34 which are at right angles to one another. Each one of surfaces 32 comprises a substantially rectangular area defined by top and bottom edges 60 and side edges 62. Likewise, each of surfaces 34 comprise a substantially rectangular area defined by top and bottom edges 60 and side edges 64. In accordance with the preferred embodiment of the present invention, edges 60 of adjacent projections 18 are coincident with one another and edges 62 and 64 are substantially the same length, such that the areas of surfaces 32, 34 are substantially equal.

As is further depicted in FIG. 3, sides 56 of the projections are generally orthogonal to surface 20. The particular angle of the sides 56 relative to surface 20 is not a critical element of the present invention, and may be other than as shown and described herein.

Likewise, as noted above, the angle of the surfaces 32, 34 relative to the surface 20 may be different than as shown and discussed above. Because the predetermined open position of the presently preferred embodiment is 45°, the surfaces 32, 34 are also oriented at 45° angles to the bail 12, and in particular, to the surface 20 of member 40. Accordingly, if the predetermined (open) position of bail 12 is different 45°, the relative angle between surface 20 and surfaces 32, 34 would also be different in order to maintain surfaces 32 and 34 in the proper relation with the back of instrument 10. That is, the angle would be such that when the bail is in the open position, surfaces 32 would be parallel to the back 13 of instrument 10 and surfaces 34 would be perpendicular thereto. Thus, an important feature of the present invention is that the surfaces 32, 34 of the stepped projections 18 of the bail 12 are parallel and perpendicular to the back 13 of the instrument 10 when the bail 12 is in the open position.

FIG. 4 illustrates an alternative embodiment of bail 12 with like elements of the bails of FIGs. 3 and 4 having similar reference numbers, except that the similar elements of FIG. 4 are primed (') for purposes of clarity. In FIG. 4, bail 12' comprises an elongate member 40' having a hinged end 16', second end 42' and sides 44' and 46' encompassing member 40'. A single column 54' of projections 18' extend outwardly from planar surface 20' and extend substantially the entire width of bail 12'. The other various features of bail 12' are generally the same as those of the preferred embodiment discussed above and illustrated in FIG 3.

FIG. 5 illustrates yet another alternative embodiment of the bail 10. Once again, common elements are similarly numbered, with the common elements in FIG. 5 being double primed ("). Stepped projections 18" extend from planar surface 40" in a single column 54', which is centrally located between sides 44", 46", and are substantially narrower than the projections 18' of the embodiment illustrated in FIG 4.

While preferred and alternative embodiments have been illustrated and described, it will be appreciated that various changes can be made without departing from the claims of the present invention. For example, the number of projections on the bail may be more or less than as illustrated in the figures and the size of the projections relative to the bail may be different. Even the size of the projections relative to one another may differ, as may the different surfaces of the projections. Likewise, the surface (20) of the bail need not be planar and instead, for example, may be wavy for cosmetic purposes.

## Claims

1. A tilt bail attached to an instrument (10) having a substantially planar back surface (13), said bail (12;12';12") comprising:
(a) an elongate member (40;40';40") having a hinged end (16;16';16") suitable for being pivotally attached to the instrument (10);
(b) a series of stepped projections (18;18';18") extending from said elongate member (40;40';40"), wherein each of said stepped projections includes a first surface (32;32') and a second surface (34;34") perpendicular to said first surface, such that when said bail (12;12';12") is rotated at said hinged end to an open position, said first surface (32;32') is substantially parallel to the planar back surface (13) of the instrument (10) and said second surface (34;34') is substantially perpendicular to the planar back surface (13) of the instrument (10).

2. A bail according to claim 1, wherein said stepped projections (18;18';18") are positioned in a column along a length of said elongate member (40;40';40").

3. A bail according to claim 1 or 2, wherein said first surface (32;32') is adjacent said second surface (34;34') of adjacent ones of said stepped projections.

4. A bail according to any preceding claim, wherein said first surface (32;32') has a first area and said second surface (34;34') has a second area, said first area being substantially equal to said second area.

5. A bail according to claim 4, wherein said first and second surfaces (32,34;32',34') have substantially rectangular shapes.

6. A tilt bail attached to an instrument holster having a substantially planar back surface, said bail comprising:
(a) an elongate member having a first end and a second end and further having a substantially planar surface between said first and second ends;
(b) means for attaching said elongate member to the instrument holster and suitable for placing said elongate member in open and closed positions;
(c) a series of stepped projections extending from said elongate member, wherein each of said projections comprise a first surface and a second surface perpendicular to said first surface, such that when said bail is placed in said open position, said first surface is substantially parallel to the planar back surface of the instrument holster and said second surface is perpendicular to the planar back surface of the instrument holster.

7. A bail according to claim 6, wherein said stepped projections are positioned in a column along a length of said elongate member.

8. A bail according to claim 6 or 7, wherein said first surface is adjacent said second surface of adjacent ones of said stepped projections.

9. A bail according to any one of claims 6 to 8, wherein said first surface has a first area and said second surface has a second area, said first area being substantially equal to said second area.

10. A bail according to claim 9, wherein said first and second surfaces have substantially rectangular shapes.

## Patentansprüche

1. Neigungsbügel, der an einem Instrument (10) mit einer im wesentlichen ebenen Rückfläche (13) angebracht ist, wobei der Bügel (12, 12', 12") aufweist:
(a) ein langgezogenes Teil (40, 40', 40") mit einem angelenkten Ende (16, 16', 16"), das geeignet ist, drehbar an dem Instrument (10) angebracht zu sein und
(b) eine Reihe sich aus dem langgezogenen Teil (40, 40', 40") erstreckender gestufter Vorsprünge, worin jeder der gestuften Vorsprünge eine erste Fläche (32, 32') und eine zu der ersten Fläche senkrechte zweite Fläche (32, 32') aufweist, so daß, wenn der Bügel (12, 12', 12") an dem angelenkten Ende in eine offene Stellung gedreht ist, die erste Fläche (32, 32') im wesentlichen parallel zu der ebenen Rückseite (13) von dem Instrument (10) ist und die zweite Fläche (34, 34') im wesentlichen senkrecht zu der ebenen Rückseite (13) von dem Instrument (10) ist.

2. Bügel nach Anspruch 1, wobei die gestuften Vorsprünge (18, 18', 18") in einer Spalte entlang einer Länge des langgezogenen Teiles (40, 40', 40") angebracht sind.

3. Bügel nach Anspruch 1 oder 2, wobei die erste Fläche (32, 32') angrenzend an die zweite Fläche (34, 34') von einander angrenzenden der gestuften Vorsprünge ist.

4. Bügel, nach irgendeinem vorhergehenden Anspruch, wobeidie erste Fläche (32, 32') einen ersten Flächeninhalt und die zweite Fläche (34, 34') einen zweiten Flächeninhalt hat und der erste Flächeninhalt im wesentlichen gleich dem zweiten Flächeninhalt ist.

5. Bügel nach Anspruch 4, wobei die erste und zweite Fläche (32, 34, 32', 34') im wesentlichen rechteckige Formen haben.

6. Neigungsbügel, der an einem Instrument-Halter mit einer im wesentlichen ebenen Rückseite angebracht ist, wobei der Bügel aufweist:
(a) ein langgezogenes Teil mit einem ersten Ende und einem zweiten Ende und weiter mit einer im wesentlichen ebenen Fläche zwischen dem ersten und zweiten Ende,
(b) eine Einrichtung zum Anbringen des langgezogenen Teils an dem Instrument-Halter und geeignet zum Setzen des langgezogenen Teiles in offene und geschlossene Stellungen und
(c) eine Reihe von sich aus dem langgezogenen Teil erstreckender gestufter Vorsprünge, wobei jeder der Vorsprünge eine erste Fläche und eine zu der ersten Fläche senkrechte zweite Fläche aufweist, so daß, wenn der Bügel in die offene Stellung gesetzt ist, die erste Fläche im wesentlichen parallel zu der ebenen Rückseite von dem Instrument-Halter ist und die zweite Fläche senkrecht zu der ebenen Rückseite von dem Instrument-Halter ist.

7. Bügel nach Anspruch 6, wobei die gestuften Vorsprünge in einer Spalte entlang einer Länge von dem langgezogenen Teil angebracht sind.

8. Bügel nach Anspruch 6 oder 7, wobei die erste Fläche angrenzend an die zweite Fläche von einander angrenzenden der gestuften Vorsprünge ist.

9. Bügel nach irgendeinem der Ansprüche 6 bis 8, wobei die erste Fläche einen ersten Flächeninhalt und die zweite Fläche einen zweiten Flächeninhalt hat und der erste Flächeninhalt im wesentlichen gleich dem zweiten Flächeninhalt ist.

10. Bügel nach Anspruch 9, wobei die ersten und zweiten Flächen im wesentlichen rechteckige Formen haben.

## Revendications

1. Support inclinable fixé à un instrument (10) qui présente une surface arrière (13) sensiblement plane, ledit support (12 ; 12' ; 12") comprenant :
(a) un élément allongé (40 ; 40' ; 40") qui est pourvu d'une extrémité articulée (16 ; 16' ; 16") apte à être montée pivotante sur l'instrument (10) ; et
(b) une série de saillies étagées (18 ; 18' ; 18") qui partent de l'élément allongé (40 ; 40' ; 40"), chacune de ces saillies étagées comprenant une première surface (32 ; 32') et une seconde surface (34 ; 34') perpendiculaire à celle-ci, de sorte que lorsqu'on fait pivoter le support (12 ; 12' ; 12"), au niveau de son extrémité articulée, jusqu'à une position ouverte, la première surface (32 ; 32') est sensiblement parallèle à la surface arrière plane (13) de l'instrument (10) tandis que la seconde surface (34; 34') est sensiblement perpendiculaire à ladite surface arrière plane (13) de l'instrument (10).

2. Support selon la revendication 1, dans lequel les saillies étagées (18 ; 18' ; 18") sont disposées en colonne sur la longueur de l'élément allongé (40 ; 40' ; 40").

3. Support selon la revendication 1 ou 2, dans lequel la première surface (32 ; 32') est voisine de la seconde surface (34 ; 34') des saillies étagées voisines.

4. Support selon l'une quelconque des revendications précédentes, dans lequel la première surface (32 ; 32') a une première superficie et la seconde surface (34 ; 34') a une seconde superficie, la première superficie étant sensiblement égale à la seconde.

5. Support selon la revendication 4, dans lequel les première et seconde surfaces (32, 34 ; 32', 34') ont une forme sensiblement rectangulaire.

6. Support inclinable fixé à un étui d'instrument qui présente une surface arrière sensiblement plane, le support comprenant :
(a) un élément allongé qui présente une première extrémité et une seconde extrémité et qui présente également une surface sensiblement plane entre les première et seconde extrémités ;
(b) des moyens pour fixer l'élément allongé à l'étui d'instrument et aptes à placer l'élément allongé dans des positions ouverte et fermée ;
(c) une série de saillies étagées qui partent de l'élément allongé, chacune de ces saillies comprenant une première surface et une seconde surface perpendiculaire à la première, de sorte que lorsque le support est placé en position ouverte, la première surface est sensiblement parallèle à la surface arrière plane de l'étui d'instrument tandis que la seconde surface est perpendiculaire à ladite surface arrière plane de l'étui.

7. Support selon la revendication 6, dans laquelle les saillies étagées sont disposées en colonne sur la longueur de l'élément allongé.

8. Support selon la revendication 6 ou 7, dans lequel la première surface est voisine de la seconde surface des saillies étagées voisines.

9. Support selon l'une quelconque des revendications 6 à 8, dans lequel la première surface a une première superficie et la seconde surface a une seconde superficie, la première superficie étant sensiblement égale à la seconde.

10. Support selon la revendication 9, dans lequel les première et seconde surfaces ont une forme sensiblement rectangulaire.
